(19) Europäisches Patentamt
European Patent Office
Office européen des brevets

(11) EP 1 020 024 B1

(12) **EUROPÄISCHE PATENTSCHRIFT**

(45) Veröffentlichungstag und Bekanntmachung des Hinweises auf die Patenterteilung:
**10.04.2002 Patentblatt 2002/15**

(21) Anmeldenummer: **98952553.0**

(22) Anmeldetag: **09.09.1998**

(51) Int Cl.[7]: **H03D 3/00**, H03D 1/22, H03D 7/16

(86) Internationale Anmeldenummer:
**PCT/DE98/02663**

(87) Internationale Veröffentlichungsnummer:
**WO 99/14852 (25.03.1999 Gazette 1999/12)**

# (54) FILTERANORDNUNG UND SLOPE-DETECTOR FÜR QUADRATURAMPLITUDENMODULIERTE SIGNALE

FILTERING ARRANGEMENT AND SLOPE DETECTOR FOR QUADRATURE AMPLITUDE MODULATED SIGNALS

DISPOSITIF FILTRANT ET DETECTEUR DE PENTE DESTINES A DES SIGNAUX A MODULATION D'AMPLITUDE DEPHASEE EN QUADRATURE

(84) Benannte Vertragsstaaten:
**DE ES FR GB IT**

(30) Priorität: **18.09.1997 DE 19741181**

(43) Veröffentlichungstag der Anmeldung:
**19.07.2000 Patentblatt 2000/29**

(73) Patentinhaber: **Micronas Munich GmbH**
**81541 München (DE)**

(72) Erfinder:
- **PRANGE, Stefan**
  **D-81476 München (DE)**
- **GEIB, Heribert**
  **D-85567 Grafing (DE)**
- **DE MAN, Erik**
  **D-81739 München (DE)**

(74) Vertreter: **Patentanwälte**
**Westphal, Mussgnug & Partner**
**Mozartstrasse 8**
**80336 München (DE)**

(56) Entgegenhaltungen:
**US-A- 4 755 761** **US-A- 4 804 924**

- **MAN DE E ET AL: "ARCHITECTURE AND CIRCUIT DESIGN OF A 6-GOPS SIGNAL PROCESSOR FOR QAM DEMODULATOR APPLICATIONS" IEEE JOURNAL OF SOLID-STATE CIRCUITS, Bd. 30, Nr. 3, 1. März 1995, Seiten 219-226, XP000502807 in der Anmeldung erwähnt**
- **PELLON L E: "A DOUBLE NYQUIST DIGITAL PRODUCT DETECTOR FOR QUADRATURE SAMPLING" IEEE TRANSACTIONS ON SIGNAL PROCESSING, Bd. 40, Nr. 7, 1. Juli 1992, Seiten 1670-1680, XP000307658**
- **YAMANAKA K ET AL: "A MULTILEVEL QAM DEMODULATOR VLSI WITH WIDEBAND CARRIER RECOVERY AND DUAL EQUALIZING MODE" IEEE JOURNAL OF SOLID-STATE CIRCUITS, Bd. 32, Nr. 7, Juli 1997, Seiten 1101-1107, XP000729369**

EP 1 020 024 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die vorliegende Erfindung betrifft eine Filteranordnung für quadraturamplitudenmodulierte (QAM-)-Signale, die insbesondere, aber nicht ausschließlich in einem Frequenzbereichsentzerrer für derartige Signale verwendbar ist, sowie einen Slope-Detector zur Erfassung einer Schräglage des Leistungsspektrums des QAM-Signals, der besonders zur Verwendung in Verbindung mit der erfindungsgemäßen Filteranordnung geeignet ist.

Quadraturamplitudenmodulation wird insbesondere in der Farbfernsehtechnik zum Aufmodulieren von zwei voneinander unabhängigen Signalen, z. B. eines Leuchtdichte- und eines Farbdifferenzsignals, auf eine gemeinsame Trägerschwingung durch Modulieren von dessen Amplitude und Phase eingesetzt. Zur Demodulation des QAM-Signals zurück in den Basisbandbereich wird das QAM-Signal mit einer mit dem ursprünglichen Träger phasengleichen (Cosinus-)-schwingung bzw. einer um 90° phasenverschobenen (Sinus-)-schwingung multipliziert und tiefpaßgefiltert, wodurch zwei Signalkomponenten erhalten werden. Diese Signalkomponenten werden im folgenden durch die Bezeichnungen I und Q unterschieden.

Filteranordnungen für derart demodulierte QAM-Signale umfassen im allgemeinen zwei weitgehend identisch aufgebaute Kanäle für die zwei Komponenten des Signals. So ist z. B. aus De Man et al., "Architecture and Circuit Design of a 6 GOPS Signal Processor for QAM Demodulator Applications", IEEE JSSC, Bd. 30, Nr.3, März 1995 eine Filteranordnung bekannt, die einen ersten Kanal für eine cosinusdemodulierte Komponente des QAM-Signals, einen zweiten Kanal für eine sinusdemodulierte Komponente des QAM-Signals, eine Filterschaltung, die die zwei Signalkomponenten empfängt und für jede Signalkomponente eine Übertragungsfunktion hat, die aus mit dieser Signalkomponente phasengleichen und aus gegen diese um $\pi/2$ und/oder $-\pi/2$ phasenverschobenen Termen zusammengesetzt ist, und einen Kreuzzweig zum Abgreifen von den phasenverschobenen Termen der Übertragungsfunktion entsprechenden Signalanteilen vom jeweils anderen Kanal umfaßt, wobei der Kreuzzweig doppelt vorhanden und jeweils einem der zwei Kanäle fest zugeordnet ist.

Eine weitere, ebenfalls aus dem zitierten Artikel von de Man et al. bekannte Filteranordnung für demodulierte QAM-Signale ist ein Slope-Detector, der die zwei Komponenten des QAM-Signals empfängt, mit einer Differenzstufe, die die Differenz zwischen einem empfangenen Datenwert und dem zu vorletzt empfangenen Datenwert derselben Komponente bildet, und einer Multiplikationsstufe, die das Produkt eines von der ersten Komponente abgeleiteten Differenzwerts mit einem von der zweiten Komponente abgeleiteten bildet, wobei getrennte Kanäle für die zwei Komponenten vorgesehen sind und jeder Kanal eine Differenzstufe und eine Multiplikationsstufe enthält.

Diese Verdopplung von Schaltungsteilen ist aufwendig und erfordert bei integrierter Ausbildung der Filteranordnung eine beträchtliche Substratfläche.

Aufgabe der Erfindung ist, Filteranordnungen für demodulierte QAM-Signale anzugeben, bei denen dieser Doppelaufwand weitgehend vermieden ist.

Eine erste Lösung dieser Aufgabe ist, bei der zuerst beschriebenen Filteranordnung eine Schalteranordnung vorzusehen, die in einem ersten Zustand den Eingang des Kreuzzweigs mit dem ersten und seinen Ausgang mit dem zweiten Kanal und in einem zweiten Zustand den Eingang des Kreuzzweigs mit dem zweiten und seinen Ausgang mit dem ersten Kanal verbindet. Diese Maßnahme macht es möglich, den Kreuzzweig jeweils alternierend dem ersten bzw. dem zweiten Kanal zuzuordnen, so daß nur noch ein Kreuzzweig erforderlich ist.

Vorzugsweise umfaßt die Schalteranordnung in jedem Kanal einen Schalter, der eintreffende Daten alternierend in dem Kanal bzw. auf den Kreuzzweig weiterleitet. Dadurch können Datenwerte einer Komponente, die nur zur Erzeugung phasenverschobener Terme im jeweils anderen Kanal benötigt werden, in dem Kanal, auf dem sie eintreffen, unterdrückt werden. So wird der betreffende Kanal von Verarbeitungstätigkeit entlastet, deren Ergebnisse später nicht benötigt werden.

Der Kreuzzweig umfaßt vorzugsweise einen Multiplizierer zum Multiplizieren mit einem Gewichtungsfaktor a. Insbesondere wenn die erfindungsgemäße Filteranordnung als Frequenzbereichsentzerrer eingesetzt werden soll, können in ihr Übertragungsfunktionen der Form

$$S_I(z) = ia + z^{-T/2} - iaz^{-T}$$

bzw.

$$S_Q(z) = -ia + z^{-T/2} + iaz^{-T}$$

für die Kanäle I und Q implementiert sein, wobei T die Taktperiode der Daten der demodulierten Signalkomponenten bezeichnet. Hier ist ein Multiplizierer ausreichend. Der Wert des Faktors a ist zweckmäßigerweise in Abhängigkeit von der durch einen Slope-Detector gemessenen Verzerrung des Signalspektrums verstellbar. Des weiteren umfaßt der Kreuzzweig vorzugsweise ein Register zum Verzögern eines Datenwerts um die Zeit T.

Es kann jedem Kanal ein Addierer zugeordnet sein, wobei die Schalteranordnung das Ausgangssignal des Kreuzzweigs jeweils alternierend einem der beiden Addierer zum Addieren zu dem auf dem betreffenden Kanal übertragenen Signal zuführt.

Eine weitere Vereinfachung ergibt sich, wenn anstelle der zwei jeweils einem Kanal zugeordneten Addierer nur ein Addierer vorgesehen wird, mit einem ersten Eingang, der durch einen Schalter alternierend mit dem ersten bzw. zweiten Kanal verbunden ist, und einem zweiten Eingang, der an den Ausgang des Kreuzzweigs angeschlossen ist.

Eine zweite Lösung der Aufgabe ist, bei dem oben beschriebenen Slope-Controller die Differenzstufe so einzurichten, daß sie alternierend Datenwerte der ersten und der zweiten Komponente empfangen kann, und die Multiplikationsstufe mit einem ersten Register auszustatten, das eingerichtet ist, um alternierend von der ersten und von der zweiten Komponente abgeleitete Differenzwerte zu speichern.

Vorzugsweise gibt dieses erste Register einen empfangenen Differenzwert mit einer Verzögerung von einer Taktperiode, entsprechend dem Zeitabstand zwischen zwei aufeinanderfolgenden Datenwerten, aus.

Zusätzlich können ein zweites Register, das eingerichtet ist, den Differenzwert mit drei Taktperioden Verzögerung auszugeben, und ein Schalter vorgesehen werden, der alternierend den Ausgang des ersten und den des zweiten Registers mit einem Multiplizierer verbindet.

Derartige Slope-Controller können insbesondere als Bestandteil einer als Frequenzbereichsentzerrer eingesetzten erfindungsgemäßen Filteranordnung Verwendung finden.

Weitere Merkmale und Vorteile der Erfindung ergeben sich aus der nachfolgenden Beschreibung von Ausführungsbeispielen mit Bezug auf die beigefügten Figuren. Es zeigen:

Fig. 1 eine erste Ausgestaltung einer erfindungsgemäßen Filteranordnung;

Fig. 2 eine zweite Ausgestaltung einer erfindungsgemäßen Filteranordnung;

Fig. 3 eine erste Ausgestaltung eines erfindungsgemäßen Slope-Detectors;

Fig. 4 eine zweite Ausgestaltung eines erfindungsgemäßen Slope-Detectors;

Fig. 5 einen herkömmlichen Frequenzbereichsentzerrer; und

Fig. 6 einen herkömmlichen Slope-Detector.

Zum leichteren Verständnis der Erfindung werden zunächst anhand der Figs. 5 und 6 ein Frequenzbereichsentzerrer und ein Slope-Detector nach dem Stand der Technik behandelt.

Der in Fig. 5 gezeigte Frequenzbereichsentzerrer ist aus dem eingangs zitierten Artikel bekannt. Er empfängt über einen Eingang 1 ein QAM-Signal, dargestellt als komplexwertige Schwingung $e^{i\omega t}$. Das Signal wird aufgeteilt auf einen (in der Zeichnung oberen) I-Kanal und einen (unteren) Q-Kanal. Ein Multiplizierer 3I im I-Kanal multipliziert das QAM-Signal mit einer mit dem Träger phasengleichen Schwingung $2e^{i\omega_0 t}$. Durch Filterung in einem Tiefpaßfilter 5I wird aus dem Produkt der Anteil mit der Differenzfrequenz abgetrennt und so eines der zwei dem Träger aufmodulierten Signale zurückgewonnen, in der Figur bezeichnet als $e^{i\omega_B t}$, wobei $\omega_B$ für die im Basisfrequenzbereich liegende Differenz zwischen $\omega$ und $\omega_0$ steht. Das zweite Signal, bezeichnet als $-ie^{i\omega_B t}$ wird im Q-Kanal analog durch Multiplizieren mit einer um $\pi/2$ phasenverschobenen Schwingung $-2ie^{i\omega_0 t}$ und Tiefpaßfilterung gewonnen. Die zwei Signalkomponenten sind selbstverständlich in der praktischen Ausführung real, die hier verwendete komplexe Schreibweise bezeichnet lediglich, daß die I-Komponente als Realteil und die Q-Komponente als negativer Imaginärteil oder, was gleichbedeutend wäre, die Q-Komponente als Realteil und die I-Komponente als Imaginärteil eines komplexwertigen Gesamtsignals aufgefaßt werden kann. Am Ausgang der Multiplizierer stehen demodulierte Datenfolgen I=(...,I(0), I(T/2), I(T), I(3T/2), I(2T),...) bzw. Q=(..., Q(0), Q(T/2), Q(T), Q(3T/2), Q(2T),...) zur Verfügung.

Diese beiden Signalfolgen werden in eine Filteranordnung 10 eingegeben, die zur Frequenzbereichsentzerrung eine Übertragungsfunktion der Form

$$S(z) = ia + z^{-T/2} - iaz^{-T}$$

realisieren soll. Da die beiden Datenfolgen I und Q sich zueinander jeweils wie Real- und negativer Imaginärteil bzw. wie Imaginär- und Realteil einer komplexwertigen Folge verhalten, läßt sich diese Übertragungsfunktion realisieren, indem man die Signalanteile des gefilterten Signals, die imaginären Termen der Übertragungsfunktion entsprechen, unter Beachtung des Vorzeichens vom jeweils anderen Kanal übernimmt.

Dies bedeutet, daß zur Erzeugung eines gefilterten Datenwerts auf dem I-Kanal jeweils ein Datenwert I([2n+1]/2) für den realen Term der Übertragungsfunktion und Werte -aQ(n) und aQ(n+1) für die zwei imaginären Terme summiert werden müssen, zur Erzeugung eines gefilterten Datenwerts auf dem Q-Kanal hingegen jeweils ein Datenwert Q([2n+1]/2) für den realen Term der Übertragungsfunktion und Werte aQ(n) und -aQ(n+1) für die zwei imaginären Terme.

Am Ausgang der Filteranordnung 10 werden die gefilterten Daten mit der Periode T ausgegeben. Es wird deshalb nur für jeden zweiten der Eingangswerte ein gefilterter Wert benötigt. Anstatt die nicht benötigten Werte am Ausgang wegzuwerfen, werden die Daten durch Schalter 7I, 7Q bereits am Eingang der Filteranordnung 10 so verteilt, daß nicht benötigte Werte auch nicht berechnet werden. Die Schalter 7I und 7Q schalten mit einer Frequenz gleich dem Doppelten der Datenausgabefrequenz der Filteranordnung die Daten I([2n+1]T/2) bzw. Q([2n+1]T/2) auf den I- bzw. Q-Kanal 17I, 17Q der Filteranordnung 10' und die Daten I(nT) bzw. Q(nT) auf die Kreuzzweige 9I bzw. 9Q.

Jeder Kreuzzweig 9I, 9Q umfaßt einen Multiplizierer 11I, 11Q, der die vom Schalter 7I bzw. 7Q durchgegebenen Daten empfängt und mit einem Gewichtungsfaktor a multipliziert. Der Wert von a ist in Abhängigkeit vom Erfassungsergebnis eines Slope-Detectors einstellbar, auf den in Verbindung mit Fig. 6 genauer eingegangen wird. Der Ausgang des Multiplizierers 11I, 11Q ist an ein Register 13I, 13Q und an einen ersten Eingang eines Addierers 15I, 15Q angeschlossen. Das Register 13I, 13Q gibt den empfangenen Datenwert um eine Taktperiode T verzögert an einen zweiten Eingang des Addierers aus. Der Addierer 15I berücksichtigt beim Addieren den vom Register kommenden, verzögerten Datenwert mit umgekehrtem Vorzeichen; der Addierer 15Q berücksichtigt den unverzögerten Datenwert mit umgekehrtem Vorzeichen. Die Übertragungsfunktionen der zwei Kreuzzweige sind somit

$$S^*_I(z) = a - az^{-T}$$

bzw.

$$S^*_Q(z) = -a + az^{-T}.$$

Im Kanal 17I bzw. 17Q ist ein weiterer Addierer 25I bzw. 25Q angeordnet, der an einem ersten Eingang Datenwerte vom Schalter 7I, 7Q über ein (nicht gezeigtes) Verzögerungselement empfängt. Das Verzögerungselement bewirkt eine Verzögerung um eine halbe Taktperiode, so daß wenn z.B. am Eingang des I-Kanals 17I der Filteranordnung der Wert I(0) anliegt, der Addierer 25I den Wert I(-T/2) empfängt. Die Übertragungsfunktion des I-Kanals bis zum Eingang des Addierers läßt sich also schreiben als

$$S^{**}_I(z) = z^{-T/2}.$$

Gleichzeitig gibt der Kreuzzweig 9Q den Wert aQ(0)-aQ(-T) an den zweiten Eingang des Addierers 25I aus. Da wie gesagt I und Q als Real- und negativer Imaginärteil einer komplexen Folge anzusehen sind, ergibt sich als Gesamtübertragungsfunktion bis zum Ausgang des Addierers

$$S_I(z) = S^{**}_I(z) - i\, S^*_Q(z) = ia + z^{-T/2} - iaz^{-T}.$$

Da umgekehrt auch I als (positiver) Imaginärteil zu Q aufgefaßt werden kann, erkennt man, daß auch gilt:

$$S_Q(z) = S^{**}_Q(z) + i\, S^*_I(z) = ia + z^{-T/2} - iaz^{-T}.$$

Die Filteranordnung 10 realisiert also die gewünschte Übertragungsfunktion S(z).

Dieser Frequenzbereichsentzerrer wurde für Richtfunkanwendungen mit Datenübertragungsraten bis 60 Mbaud vorgeschlagen.

Bei niedrigeren Übertragungsraten von z. B. 7 Mbaud bei der Übertragung von Videodaten über Kabel ist es möglich, den Schaltungsaufwand zu verringern, indem Schaltungsteile nicht doppelt vorgesehen und parallel betrieben, sondern zeitlich mehrfach genutzt werden. Fig. 1 zeigt ein erstes Beispiel eines Entzerrers mit einer erfindungsgemäßen Filteranordnung 10', bei der dies der Fall ist.

Der Eingang 1 des Entzerrers empfängt ein QAM-Signal mit der Symbolfrequenz f=1/T. Multiplizierer 3I, 3Q und Tiefpaßfilter 5I, 5Q sind dieselben wie beim Entzerrer aus Fig. 5, weswegen sie hier nicht erneut beschrieben werden. An den Ausgang jedes Tiefpaßfilters 5I, 5Q ist ein Schalter 7I bzw. 7Q angeschlossen, der die mit doppelter Symbolfrequenz eintreffenden Daten ...I(-1/2), I(0), I(1/2), I(1),... bzw. ...Q(-1/2), Q (0), Q(1/2), Q(1),... abwechselnd auf einen zugeordneten Kanal 17I, 17Q, der jeweils einen Addierer 25I bzw. 25Q enthält, bzw. zu einem ersten Element 19 einer Schalteranordnung weitergibt. Dieser erste Schalter 19 gibt die ihm zugeleiteten Daten alternierend an einen nachfolgenden Kreuzzweig 9 weiter und erzeugt so eine zeitlich verschachtelte Datenfolge Q(-1), I(-1), Q(0), I (0), Q(1), I(1),....

Der Kreuzzweig 9 umfaßt einen Multiplizierer 11, der die vom ersten Schalter 19 ausgegebenen Daten mit einem Gewichtungsfaktor a multipliziert. Der Multiplizierer arbeitet mit dem Zweifachen der Symbolfrequenz f als Taktfrequenz.

Ein Register 13 ist an den Ausgang des Multiplizierers 11 angeschlossen. Es ist als FIFO-Register mit einer Speichertiefe von zwei Plätzen aufgebaut, so daß es zu jedem Zeitpunkt die zwei unmittelbar vorhergehenden Datenwerte enthält und bei Eintreffen eines neuen Wertes den älteren der beiden gespeicherten ausgibt. So sind z.B. wenn der Multiplizierer den Wert aI(n) ausgibt, im Register die Werte aQ(n) und aI(n-1) (n= ..., -1, 0, 1, 2, ...) gespeichert, und der Wert aI(n-1) wird ausgegeben.

Ein Addierer 15 mit zwei Eingängen ist über einen Eingang mit dem Multiplizierer 11 und über den anderen mit dem Ausgang des Registers 13 verbunden. Er bildet die Summe aus dem Ausgabedatenwert des Registers 13 und dem negativen Datenwert des Multiplizierers 11, also aI(n-1)-aI(n).

Am Ausgang des Kreuzzweigs 9 ist ein zweiter Schalter 21 vorgesehen, der in der Weise synchronisiert mit dem ersten Schalter betrieben wird, daß immer dann, wenn der erste Schalter 19 Daten vom Q-Kanal empfängt, der zweite Schalter mit dem I-Kanal verbunden ist und umgekehrt.

Ein Ausgang des zweiten Schalters 21 ist direkt mit dem Addierer 25I des I-Kanals 17I verbunden.

Ein Verzögerungsglied (nicht dargestellt) im I-Kanal gewährleistet, daß wenn ein Wert aQ(n-1)-aQ(n) vom Kreuzzweig an den Addierer 15I ausgegeben wird, an dessen anderem Eingang der Wert I(n-1/2) anliegt. Der Addierer 25I gibt dann den entzerrten Datenwert

$$I(n-1/2) + aQ(n-1) - aQ(n)$$

aus.

Der zweite Ausgang des zweiten Schalters 21 ist mit dem Q-Kanal-Addierer 25Q über einen Vorzeichenvertauscher 27 verbunden, so daß auf dem Q-Kanal 17Q jeweils entzerrte Datenwerte

$$Q(n-1/2) - aI(n-1) + aI(n)$$

ausgegeben werden.

Das Ergebnis der Verarbeitung im Entzerrer nach Fig. 1 ist also dasselbe wie beim Entzerrer nach Fig. 5; allerdings wird beim Entzerrer nach Fig. 1 dieses Ergebnis mit nur einem Kreuzzweig 9 erzielt.

Zur Ermittlung des Gewichtungsfaktors a muß die Differenz der Leistungsdichten im oberen und unteren Seitenband des übertragenen QAM-Signals ermittelt werden. Fig. 6 zeigt einen Slope-Detector, mit dem diese Differenz am ins Basisband transformierten Signal möglich ist. Im Basisband entsprechen oberes und unteres Seitenband positiver und negativer "Drehrichtung" des QAM-Signals. Diese können durch Filter mit den Übertragungsfunktionen

$$F_{ub} = 1 + i\,z^{-1} - z^{-2} - i\,z^{-3}$$

bzw.

$$F_{lb} = -1 + i\,z^{-1} + z^{-2} - i\,z^{-3}$$

getrennt werden, wobei die Indizes ub für das obere Seitenband (upper band) und lb für das untere Seitenband (lower band) stehen.

Die Differenz der Leistungsdichten ist gegeben durch

$$I_u^2 - I_l^2 + Q_u^2 - Q_l^2$$

Zur Bestimmung von $I_u^2 - I_l^2$ werden mit obigen Übertragungsfunktionen gefilterte Daten

$$I_u = I(0) + iI(-1) - I(-2) - iI(-3)$$

$$= I(0) + -Q(-1) - I(-2) + Q(-3)$$

und

$$I_l = -I(0) + iI(-1) + I(-2) - iI(-3)$$

$$= -I(0) + -Q(-1) + I(-2) + Q(-3)$$

quadriert und voneinander subtrahiert. Dies läßt sich über die Beziehung

$$I_u^2 - I_l^2 = (I_u - I_l)\,(I_u + I_l)$$

$$= 4[-Q(-1) + Q(-3)]\,[I(0) - I(-2)]$$

realisieren. Zur Bestimmung von $Q_u^2 - Q_l^2$ wird analog verfahren.

Die Summe $I_u^2 - I_l^2 + Q_u^2 - Q_l^2$ kann mit dem in Fig. 6 gezeigten Slope-Detector berechnet werden. Der Slope-Detector empfängt die zwei Komponenten eines QAM-Signals auf getrennten Eingängen 51I, 51Q getrennter Schaltungszweige. Eine Differenzstufe, jeweils bestehend aus einem um zwei Takte verzögernden Register 53I, 53Q und einem Addierer 55I, 53Q mit invertierendem Eingang, bildet die Differenz zwischen einem empfangenen Datenwert und dem zwei Takte zuvor empfangenen Datenwert derselben Komponente. Das Ausgangssignal jedes Addierers 55I, 55Q ist an ein um einen Takt verzögerndes Register 57I, 57Q und einen Eingang eines Multiplizierers 59Q, 59I des jeweils anderen Schaltungszweiges angeschlossen. Der zweite Eingang des Multiplizierers 59I, 59Q ist an den Ausgang des Registers 57I, 57Q des jeweils gleichen Schaltungszweigs angeschlossen. Wie man leicht erkennt, geben zu einem Zeitpunkt die Addierer 55I, 55Q die Werte -I(0)+I(-2) bzw. - Q(0)+Q(-2), die Register 57I, 57Q die Werte -I(-1)+I(-3) bzw. -Q(-1)+Q(-3) und die Multiplizierer 59I, 59Q die Werte [-I(-1)+I(-3)] [-Q(0)+Q (-2)] und [-Q(-1)+Q(-3)][-I(0)+I(-2)] aus. Ein Addierer 61 mit invertierendem Eingang bildet die Differenz der zwei Produkte. Ein Multiplizierer zum Kalibrieren des Ergebnisses durch Multiplizieren mit dem Faktor 4 und ein Akkumulator 83 zum zeitlichen Mitteln schließen sich an den Ausgang des Addierers 61 an.

Diese Schaltung kann parallel zum Entzerrer geschaltet sein und dieselben Eingangssignale wie dieser verarbeiten, sie kann aber auch dem Entzerrer nachgeschaltet sein. In letzterem Fall kann eine einfache Rückkopplungssteuerung vorgesehen werden, die das Ausgangssignal des Slope-Detectors empfängt und den Faktor a so regelt, das dessen Ausgangssignal minimal wird. Da in diesem Fall nur relative Werte des Ausgangssignals benötigt werden, kann der Kalibrier-Multiplizierer entfallen.

Fig. 2 zeigt eine zweite Ausgestaltung eines Frequenzbereichsentzerrers mit einer erfindungsgemäßen Filteranordnung 10''. Multiplizierer 3I, 3Q, Tiefpaßfilter 5I, 5Q und Schalter 7I, 7Q sind dieselben wie bei den Entzerrern der Figs. 5 und 1. Auch der erste Schalter 19 der Filteranordnung sowie die Elemente Multiplizierer 11, Register 13 und Addierer 15 des Kreuzzweigs 9 sind dieselben wie bei der Filteranordnung 10' aus Fig. 1. Diese Elemente werden daher nicht erneut beschrieben. Der Schalter 21 aus Fig. 1 ist durch einen Schalter 23 ersetzt, der Daten von den Kanälen 17I, 17Q abwechselnd empfängt und als zeitverschachtelte Folge an einen Addierer 25 weiterleitet.

Der Kreuzzweig 9 enthält als zusätzliches Element einen Vorzeichenvertauscher 27', der vom Addierer 15 abwechselnd Datenwerte der Form aQ(n)-aQ(n-1) bzw. aI(n)-aI(n-1) empfängt und die I-Werte mit unverändertem Vorzeichen, die Q-Werte aber mit vertauschtem Vorzeichen an den Addierer 25 weitergibt.

Die Schalter 19 und 23 ist so miteinander synchronisiert, daß wenn der Kreuzzweig 9 einen Wert der Form aQ(n)-aQ(n-1) ausgibt, ein passend verzögerter Wert I(n-1/2) vom Schalter 19 am zweiten Eingang des Addierers 25 anliegt, bzw. daß ein Wert aI(n)-aI(n-1) am Addierer 25 auf einen Wert Q(n-1/2) trifft. Der Addierer 25 erzeugt somit eine Folge von Daten

$$I(-1/2) + aQ(-1) - aQ(0)$$

$$Q(-1/2) - aI(-1) + aI(0)$$

$$I(1/2) + aQ(0) - aQ(1)$$

$$Q(1/2) - aI(0) + aI(1)$$

$$I(3/2) + aQ(1) - aQ(2)$$

$$Q(3/2) - aI(1) + aI(2)$$

...,

die jeweils abwechselnd aus gefilterten Elementen der Folgen I und Q herrühren.

Diese Folge kann demultiplext und an die Eingänge des Slope-Detectors aus Fig. 6 angelegt werden, um den Gewichtungsfaktor a für die Entzerrung zu bestimmen.

Eine vorteilhafte Ausgestaltung eines Slope-Detectors, der sich besonders zur Verwendung mit den Entzerrern aus Figs. 1 und 2 eignet, ist in Fig 3 gezeigt.

Dem Slope-Detector ist ein Multiplexer 71 vorgeschaltet, der I- und Q-Signalkomponenten bzw. Datenfolgen von den Ausgängen des Entzerrers aus Fig. 1 empfängt und zu einer abwechselnd aus I- und Q-Elementen bestehenden Folge ..., I(-1) , Q(-1), I(0), Q(0), I (1), Q(1),... zusammensetzt.

Wenn der Slope-Detector mit dem Entzerrer aus Fig. 2 eingesetzt wird, kann dieser Multiplexer entfallen, da die Ausgabefolge dieses Entzerrers bereits aus abwechselnden I- und Q-Werten besteht.

Im Gegensatz zum Slope-Detector aus Fig. 6 besitzt dieser nur einen Eingang 51 und eine Differenzstufe mit einem um zwei Takte verzögernden Register 53 und einem Addierer 55 mit invertierendem Eingang, der die Differenz zwischen einem empfangenen Datenwert und dem zwei Takte zuvor empfangenen Datenwert derselben Komponente bildet. Da in diesen Slope-Detector in jedem Takt zwei Datenwerte, ein I-Wert und ein Q-Wert, eingegeben werden, hat das Register 53 ein Speichervermögen von vier Plätzen.

Die Differenzstufe erzeugt eine Folge der Form

$$-I(-1)+I(-3),\ -Q(-1)+(Q(-3),\ -I(0)+I(-2),\ -Q(0)+Q(-2),$$

$$-I(1)+I(-1),\ -Q(1)+(Q(-1),\ -I(2)+I(0),\ -Q(2)+Q(0),$$

...

An den Ausgang des Addierers 55 sind parallel zueinander zwei Register 73, 75 angeschlossen, die eintreffende Werte jeweils um eine halbe bzw. drei halbe Taktperioden verzögern. Ein Schalter 77 verbindet den Ausgang jeweils eines der Register 73, 75 mit dem Eingang eines Multiplizierers 79 und wird mit halber Taktperiode zwischen den zwei Registern umgeschaltet. Der andere Eingang des Multiplizierers ist direkt mit dem Addierer 55 verbunden.

Steht am Eingang 51 der Datenwert I(0), so wird dem Multiplizierer direkt vom Addierer 55 der Wert -I(0)+I(-2) und vom Register 73 der Wert -Q(-1)+Q(-3) zugeführt. Einen halben Takt später liegen am Multiplizierer die Werte -Q(0)+Q(-2) und -um eineinhalb Takte verzögert, vom Register 75--I(-1)+I(-3) an. Es werden so für den Takt 0 zwei Produkte erzeugt, die jeweils ein Maß für $I_u^2 - I_l^2$ und $Q_l^2 - Q_u^2$ darstellen und auf Daten der Takte -3 bis 0 basieren.

Der Multiplizierer 79 gibt die beiden Produkte an einen Vorzeichenvertauscher 81 weiter, der das Vorzeichen jedes zweiten eintreffenden Werts umkehrt. Ein Akkumulator 83 addiert die vom Vorzeichenvertauscher eintreffenden Werte zu einem gleitenden Mittelwert auf.

Wie man mit Bezug auf die Beschreibung von Fig. 6 leicht erkennt, gibt die Summe von jeweils zwei aufeinanderfolgenden Ausgabewerten des Vorzeichenvertauschers 81 die Differenz der Leistungsdichten $I_u^2 - I_l^2 + Q_u^2 - Q_l^2$ an. Die Schaltung nach Fig. 3 liefert somit dasselbe Ergebnis wie die aus Fig. 6, kommt dafür aber mit nur einer Differenzstufe und ohne den Addierer 61 aus, dessen Funktion mit vom Akkumulator 83 übernommen ist.

Fig. 4 zeigt eine weiter vereinfachte Ausgestaltung des Slope-Detectors aus Fig. 3. Bei diesem Slope-Detector sind Register 75 und Schalter 77 entfallen, so daß der Multiplizierer 79 verzögerte Werte immer vom Register 73 empfängt. Er bildet somit eine Folge von Produkten der Form

$$[-Q(-1)+(Q(-3)] [-I(0)+I(-2)],$$

$$[-Q(0)+Q(-2)] [-I(1)+I(-1)],$$

$$[-Q(1)+Q(-1)] [-I(2)+I(0)],$$

$$[-Q(2)+Q(0)] [-I(3)+I(1)],...$$

Der erste und der dritte der obigen Terme sind jeweils ein Maß für $I_u^2 - I_l^2$, der zweite und vierte für $Q_l^2 - Q_u^2$. Diese Folge unterscheidet sich von der vom Multiplizierer 79 der Schaltung aus Fig. 3 dadurch, daß aufeinanderfolgende Produkte nicht paarweise von Daten der gleichen Takte abgeleitet sind. Vielmehr folgt auf den ersten, von Daten der Takte -3 bis 0 abgeleiteten $I_u^2 - I_l^2$-Term ein $Q_l^2 - Q_u^2$-Term, der aus Daten der Takte -2 bis 1 berechnet ist. Da Änderungen der Leistungsverteilung aber im Vergleich zur Arbeitsfrequenz des Slope-Detectors langsam erfolgen und das zur Regelung des Faktors a verwendete Ausgangssignal des Slope-Detectors über eine Vielzahl von Takten gemittelt ist, hat diese Änderung keine Wirkung auf das Ausgangssignal.

**Patentansprüche**

1. Filteranordnung für ein demoduliertes QAM-Signal, mit einem ersten Kanal (17I) für eine cosinusdemodulierte Komponente des QAM-Signals,
einem zweiten Kanal (17Q) für eine sinusdemodulierte Komponente des QAM-Signals,
einer Filterschaltung (10', 10''), die die zwei Signalkomponenten empfängt und für jede Signalkomponente eine Übertragungsfunktion hat, die aus mit dieser Signalkomponente phasengleichen und aus gegen diese um π/2 und/oder -π/2 phasenverschobenen Termen zusammengesetzt ist, und einen Kreuzzweig (9) zum Abgreifen von den phasenverschobenen Termen der Übertragungsfunktion entsprechenden Signalanteilen vom jeweils anderen Kanal umfaßt,
**gekennzeichnet durch**
eine Schalteranordnung (19, 21; 19, 23), die in einem ersten Zustand den Eingang des Kreuzzweigs (9) mit dem ersten (17I) und seinen Ausgang mit dem zweiten Kanal (17Q) und in einem zweiten Zustand den Eingang des Kreuzzweigs (9) mit dem zweiten (17Q) und seinen Ausgang mit dem ersten Kanal (17I) verbindet.

2. Filteranordnung nach Anspruch 1,
**dadurch gekennzeichnet, daß** jeder Kanal (17I, 17Q) einen Schalter (7I, 7Q) umfaßt, der eintreffende Daten alternierend in dem Kanal (17I, 17Q) bzw. auf den Kreuzzweig (9) weiterleitet.

3. Filter nach Anspruch 1 oder 2,
**dadurch gekennzeichnet, daß** der Kreuzzweig (9) einen Multiplizierer (11) zum Multiplizieren mit einem Gewichtungsfaktor a eines phasenverschobenen Terms enthält.

4. Filter nach einem der vorhergehenden Ansprüche,
**dadurch gekennzeichnet, daß** der Kreuzzweig (9) wenigstens ein Verzögerungsregister (13) enthält.

5. Filter nach einem der vorhergehenden Ansprüche,
**dadurch gekennzeichnet, daß** die phasenverschobenen Terme der zwei Übertragungsfunktionen entgegengesetzt gleich sind.

6. Filter nach einem der vorstehenden Ansprüche,
**dadurch gekennzeichnet, daß** jedem Kanal (17I, 17Q) ein Addierer (25I, 25Q) zugeordnet ist, der jeweils die Verbindung des Ausgangs des Kreuzzweigs (9) mit dem zugeordneten Kanal (17I, 17Q) bildet.

7. Filter nach Anspruch 6,
**dadurch gekennzeichnet, daß** die zwei Addierer (25I, 25Q) den über den Kreuzzweig (9) übertragenen Signalanteil mit jeweils unterschiedlichen Vorzeichen zur auf dem Kanal (17I, 17Q) übertragenen Signalkomponente addieren.

8. Filter nach einem der Ansprüche 1 bis 5,
**gekennzeichnet durch** einen Addierer (25) mit einem ersten Eingang, der **durch** einen Schalter (23) alternierend mit dem ersten bzw. zweiten Kanal (17I, 17Q) verbunden ist, und einem zweiten Eingang, der an den Ausgang des Kreuzzweigs (9) angeschlossen ist.

9. Filter nach Anspruch 8,
**dadurch gekennzeichnet, daß** der Kreuzzweig (9) einen Vorzeichenvertauscher (27') enthält, der das Vorzeichen des Signalanteils entsprechend dem Zustand der Schalteranordnung (19, 23) alternierend vertauscht bzw. nicht vertauscht.

10. Filter nach Anspruch 3,
**gekennzeichnet durch** einen Slope-Detector, der eine Differenz der Leistungsdichten im oberen und unteren Seitenband des QAM-Signals detektiert und den Gewichtungsfaktor a steuert, um die Differenz zu minimieren.

**11.** Slope-Detector, der die zwei Komponenten eines QAM-Signals empfängt, mit einer Differenzstufe (53, 55), die die Differenz zwischen einem empfangenen Datenwert und dem zu vorletzt empfangenen Datenwert derselben Komponente bildet, und einer Multiplikationsstufe (73, 79; 73, 75, 79), die das Produkt eines von der ersten Komponente abgeleiteten Differenzwerts mit einem von der zweiten Komponente abgeleiteten bildet, **dadurch gekennzeichnet, daß** die Differenzstufe (53, 55) eingerichtet ist, alternierend Datenwerte der ersten und der zweiten Komponente zu empfangen, und daß die Multiplikationsstufe (73, 79; 73, 75, 79) ein erstes Register (73) umfaßt, das eingerichtet ist, um alternierend von der ersten und von der zweiten Komponente abgeleitete Differenzwerte zu speichern.

**12.** Slope-Detector nach Anspruch 11, **dadurch gekennzeichnet, daß** das erste Register (73) eingerichtet ist, den Differenzwert mit einer halben Taktperiode Verzögerung auszugeben.

**13.** Slope-Detector nach Anspruch 11 oder 12, **dadurch gekennzeichnet, daß** die Multiplikationsstufe (73, 75, 79) ein zweites Register (75), das eingerichtet ist, den Differenzwert mit eineinhalb Taktperioden Verzögerung auszugeben, und einen Schalter (77) umfaßt, der alternierend den Ausgang des ersten (73) und den des zweiten Registers (75) mit einem Multiplizierer (79) verbindet.

**14.** Filter nach Anspruch 10, **dadurch gekennzeichnet, daß** er ein Frequenzbereichsentzerrer ist und einen Slope-Detector nach einem der Ansprüche 11 bis 13 umfaßt.

## Claims

**1.** A filter arrangement for a demodulated QAM signal, having a first channel (17I) for a cosine-demodulated component of the QAM signal,
a second channel (17Q) for a sine-demodulated component of the QAM signal,
a filter circuit (10', 10", which receives the two signal components and for each signal component has a transmission function, which is composed of terms which are in phase with this signal component and of terms which are phase-shifted towards them by $\pi/2$ and/or $-\pi/2$, and a cross branch (9) for tapping signal parts corresponding to phase-shifted terms of the transmission function from the respective other channel,
**characterised by** a switch arrangement (19, 21; 19, 23), which in a first state connects the input of the cross branch (9) with the first channel (17I) and its output with the second channel (17Q) and in a second state connects the input of the cross branch (9) with the second channel (17Q) and its output with the first channel (17I).

**2.** A filter arrangement according to Claim 1, **characterised in that** each channel (17I, 17Q) comprises a switch (7I, 7Q), which transmits arriving data alternately in the channel (17I, 17Q) or to the cross branch (9).

**3.** A filter according to Claim 1 or 2, **characterised in that** the cross branch (9) contains a multiplier (11) for multiplying with a weighting factor a of a phase-shifted term.

**4.** A filter according to one of the preceding Claims, **characterised in that** the cross branch (9) contains at least one delay register.

**5.** A filter according to one of the preceding Claims, **characterised in that** the phase-shifted terms of the two transmission functions are opposite and equal.

**6.** A filter according to one of the preceding Claims, **characterised in that** an adder (25I, 25Q), which in each case forms the connection of the output of the cross branch (9) with the associated channel (17I, 17Q), is assigned to each channel (17I, 17Q).

**7.** A filter according to Claim 6, **characterised in that** the two adders (25I, 25Q) add the signal part transmitted via the cross branch (9) with signs that are in each case different to produce the signal component transmitted on the channel (17I, 17Q).

**8.** A filter according to one of Claims 1 to 5, **characterised by** an adder (25) with a first input, which is connected by a switch (23) alternately to a first and second channel (17I, 17Q), and a second input which is connected to the output of the cross branch (9).

**9.** A filter according to Claim 8, **characterised in that** the cross branch (9) contains a sign commutator (27'), which alternately commutates or does not commutate the sign of the signal part according to the state of the switch arrangement (19, 23).

**10.** A filter according to Claim 3, **characterised by** a slope detector which detects a different in the power densities in the upper and lower sideband of the QAM signal and controls the weighting factor a to minimise the difference.

**11.** A slope detector which receives two components of a QAM signal, having a zero stage (53, 55), which forms the difference between a received data value and the penultimate received data value of the same component, and a multiplication stge (73, 79'; 73, 75,79), which forms the product of a difference value derived from the first component with one derived from the second component,
**characterised in that** the zero stage (53, 55) is equipped to receive alternately data values of the first and the second components,
**and in that** the multiplication state (73, 79; 73, 75, 79) comprises a first register (73), which is equipped to store difference values alternately derived from the first and from the second components.

**12.** A slope detector according to Claim 11,
**characterised in that** the first register (73) is equipped to output the difference value with half a clock pulse period delay.

**13.** A slope detector according to Claim 11 or 12,
**characterised in that** the multiplication stage (73, 75, 79) comprises a second register (75), which is equipped to output the difference value with one and a half clock pulse periods delay, and a switch (77), which alternately connects the output of the first register (73) and that of the second register (75) with a multiplier (79).

**14.** A filter according to Claim 10,
**characterised in that** it is a frequency domain equaliser and comprises a slope detector according to one of Claims 11 to 13.

**Revendications**

**1.** Montage de filtres pour un signal QAM démodulé comprenant un premier canal (17I) pour une composante démodulée en cosinus du signal QAM,
un second canal (17Q) pour une composante démodulée en sinus du signal QAM,
un circuit de filtres (10', 10") qui reçoit les secondes composantes du signal et qui pour chaque composante du signal, possède une fonction de transfert formée de termes en phase avec cette composante de signal et de termes déphasés de $\pi/2$ ou $-\pi/2$ par rapport à ceux-ci, ainsi qu'une branche croisée (9) pour prélever les parties de signal correspondant aux termes déphasés de la fonction de transfert de l'autre canal,
**caractérisé par**
un montage (19, 21 ; 19, 23) qui, dans un premier état, relie l'entrée de la branche croisée (9) au premier canal (17I) et sa sortie au second canal (17Q) et qui dans un second état relie l'entrée de la branche croisée (9) au second canal (17Q) et sa sortie au premier canal (17I).

**2.** Montage de filtres selon la revendication 1,
**caractérisé en ce que**
chaque canal (17I, 17Q) comprend un commutateur (7I, 7Q) qui applique alternativement les données d'entrée au canal (17I, 17Q) ou à la branche croisée (9).

**3.** Montage de filtres les revendications 1 ou 2,
**caractérisé en ce que**
la branche croisée (9) comporte un multiplicateur (1) pour multiplier un terme déphasé avec un coefficient de pondération (a).

**4.** Montage de filtres selon l'une quelconque des revendications précédentes,
**caractérisé en ce que**
la branche croisée (9) comporte au moins un registre retardé (13).

**5.** Montage de filtres selon l'une quelconque des revendications précédentes
**caractérisé en ce que**
les termes déphasés des deux fonctions de transport sont identiques mais opposés.

**6.** Montage de filtres selon l'une quelconque des revendications précédentes,
**caractérisé en ce que**
chaque canal (17I, 17Q) comporte un additionneur (25I, 25Q) qui forme chaque fois la liaison entre la sortie de la branche croisée (9) et le canal associé (17I, 17Q).

**7.** Montage de filtres selon la revendication 6,
**caractérisé en ce que**
les deux additionneurs (25I, 25Q) additionnent la partie de signal transmise par la branche croisée (9) avec chaque fois un signe algébrique différent aux composantes de signal transmises par le canal (17I, 17Q).

**8.** Montage de filtres selon l'une quelconque des revendications 1 à 5,
**caractérisé par**
un additionneur (25) avec une première entrée reliée en alternance par un commutateur (23) au premier ou au second canal (17I, 17Q) et une seconde entrée reliée à la sortie de la branche croisée (9).

**9.** Montage de filtres selon la revendication 8,
**caractérisé en ce que**
la branche croisée (9) comporte un échangeur de signe algébrique (27') qui échange le signe algébrique de la partie de signal en fonction de l'état du montage de commutateurs (19, 23), en échangeant par alternance.

**10.** Montage de filtres selon la revendication 3,

**caractérisé par**
un détecteur de pente qui détecte une différence des densités de puissance dans la bande latérale supérieure et la bande latérale inférieure du signal QAM et commande le coefficient de pondération (a) pour minimiser la différence.

**11.** Détecteur de pente recevant deux composantes d'un signal QAM et comprenant un étage de différence (53, 55) qui forme la différence entre une valeur de données reçue et la valeur de données reçue en dernier lieu de la même composante ainsi qu'un étage de multiplication (73, 79 ; 73, 75, 79) qui forme le produit d'une valeur de différence déduite de la première composante et d'une valeur déduite de la seconde composante,
**caractérisé en ce que**
l'étage de différence (53, 55) reçoit en alternance des valeurs de données de la première et de la seconde composantes et,
l'étage de multiplication (73, 79 ; 73, 75, 79) comprend un premier registre (73) qui mémorise alternativement les valeurs de différence entre la première et la seconde composantes.

**12.** Détecteur de pente selon la revendication 11,
**caractérisé en ce que**
le premier registre (73) émet la valeur de différence avec un retard d'une demi-période.

**13.** Détecteur de pente selon les revendications 11 ou 12,
**caractérisé en ce que**
l'étage de multiplication (73, 75, 79) est un second registre (75) conçu pour fournir la valeur de la différence avec un retard d'une période et demie et un commutateur (77) reliant alternativement la sortie du premier multiplicateur et celle du second registre (75) à un multiplicateur (79).

**14.** Filtre selon la revendication 10,
**caractérisé en ce qu'**
il constitue un correcteur de plage de fréquences et comporte un détecteur de pente selon l'une quelconque des revendications 11 à 13.

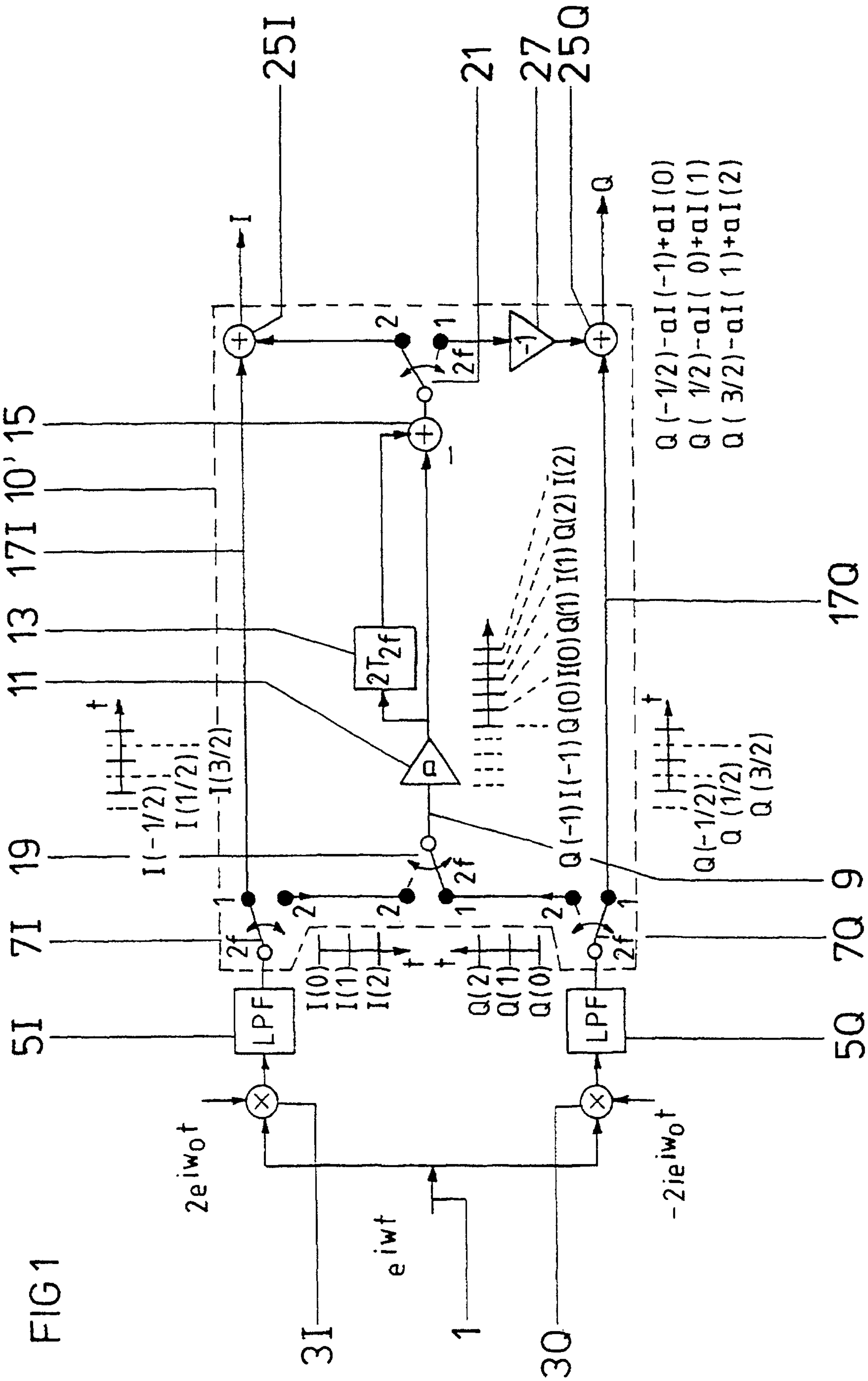
25I
21
27
25Q
17I
10'
15
13
11
17Q
19
9
7I
7Q
5I
5Q
3I
1
3Q
LPF
LPF
2T2f
a
-1
2f
I
Q
$e^{iwt}$
$2e^{iw_0t}$
$-2ie^{iw_0t}$
I(0)
I(1)
I(2)
Q(2)
Q(1)
Q(0)
I(-1/2)
I(1/2)
I(3/2)
Q(-1/2)
Q(1/2)
Q(3/2)
Q(-1) I(-1) Q(0) I(0) Q(1) I(1) Q(2) I(2)
Q(-1/2)-aI(-1)+aI(0)
Q(1/2)-aI(0)+aI(1)
Q(3/2)-aI(1)+aI(2)

FIG 1

FIG 2

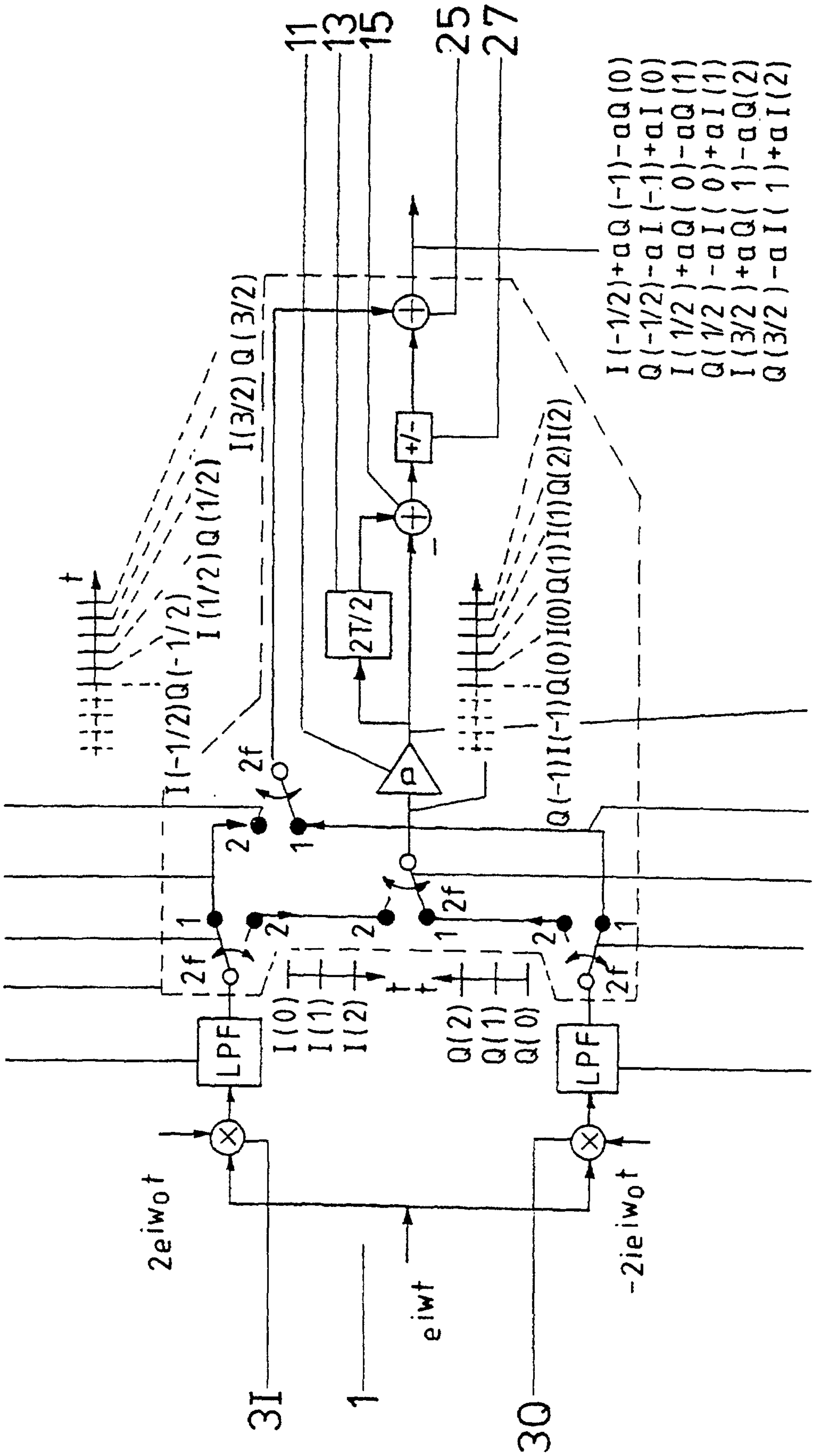
11
13
15
25
27'
5I
10"
7I
17I
23
9
17Q
19
7Q
5Q
3I
1
3Q
LPF
LPF
2T/2
+/-
a
2f
$2e^{iw_0t}$
$-2ie^{iw_0t}$
$e^{iwt}$
I(-1/2)+aQ(-1)-aQ(0)
Q(-1/2)-aI(-1)+aI(0)
I(1/2)+aQ(0)-aQ(1)
Q(1/2)-aI(0)+aI(1)
I(3/2)+aQ(1)-aQ(2)
Q(3/2)-aI(1)+aI(2)

FIG 3

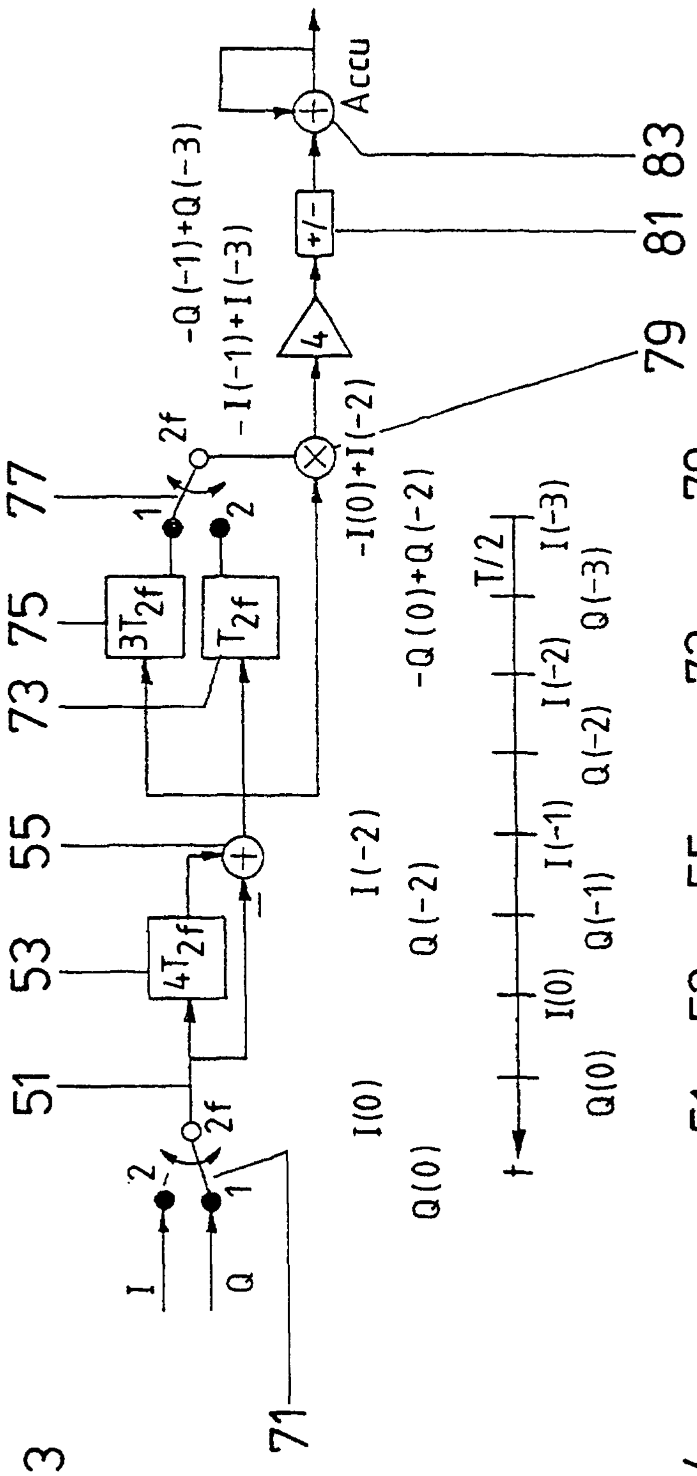

51
53
55
73
75
77
79
81
83
71
I
Q
2f
4T2f
3T2f
T2f
4
+/-
Accu
I(0)
Q(0)
I(-2)
Q(-2)
-Q(0)+Q(-2)
-I(0)+I(-2)
-I(-1)+I(-3)
-Q(-1)+Q(-3)
T/2
t


FIG 4

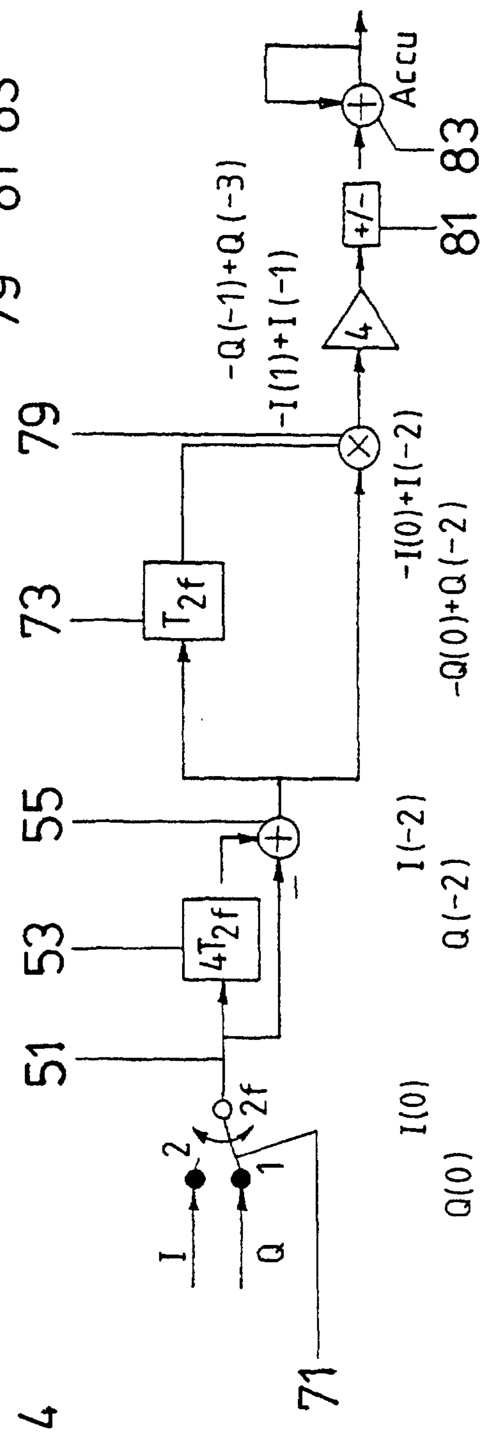

51
53
55
73
79
81
83
71
I
Q
2f
4T2f
T2f
4
+/-
Accu
I(0)
Q(0)
I(-2)
Q(-2)
-Q(0)+Q(-2)
-I(0)+I(-2)
-I(1)+I(-1)
-Q(-1)+Q(-3)

FIG 5

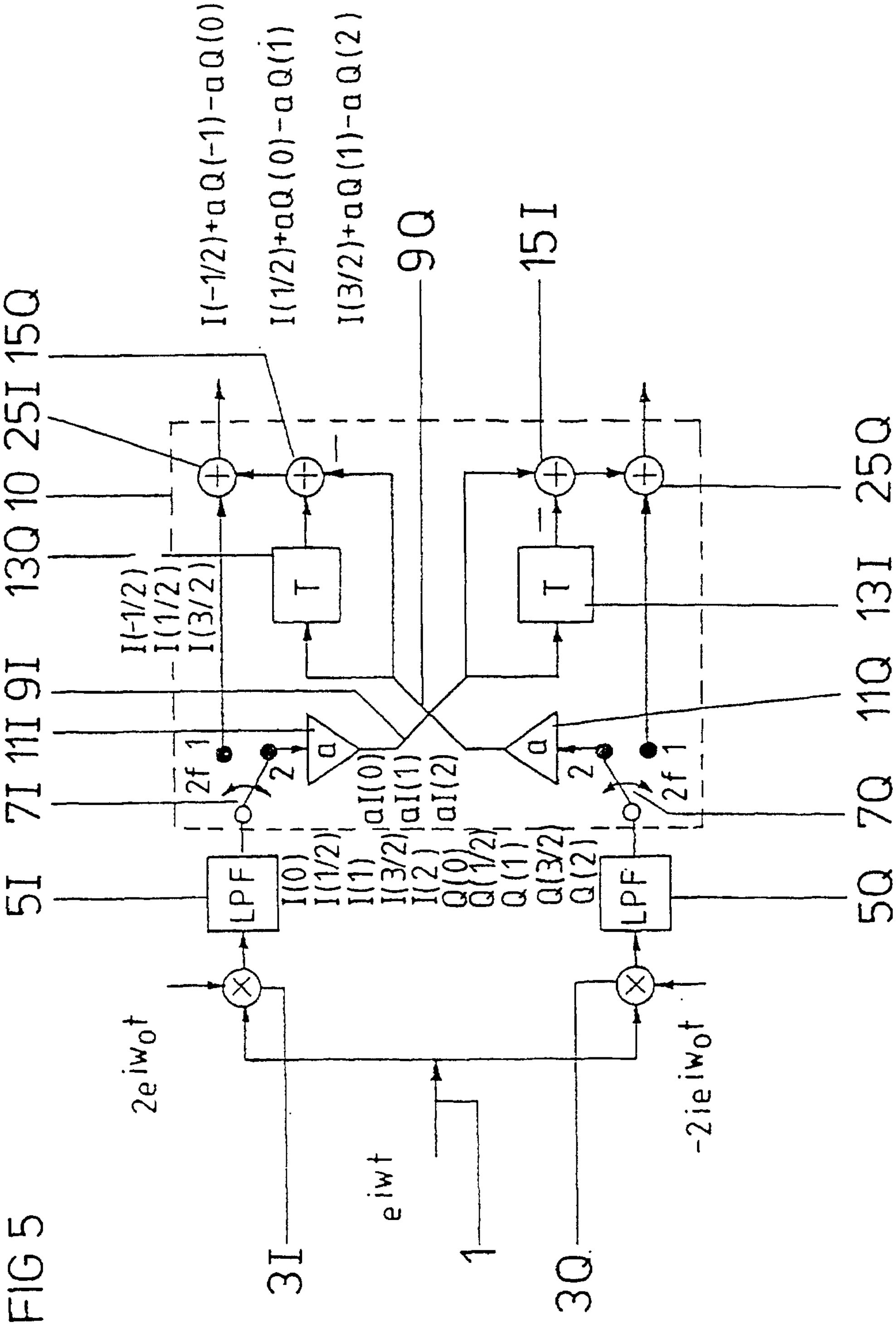
5I
7I
11I
9I
13Q
10
25I
15Q
I(−1/2)+aQ(−1)−aQ(0)
I(1/2)+aQ(0)−aQ(1)
I(3/2)+aQ(1)−aQ(2)
9Q
15I
25Q
13I
11Q
7Q
5Q
LPF
T
a
2f 1
2
I(−1/2)
I(1/2)
I(3/2)
I(0)
I(1/2)
I(1)
I(3/2)
I(2)
Q(0)
Q(1/2)
Q(1)
Q(3/2)
Q(2)
aI(0)
aI(1)
aI(2)
3I
1
3Q
$e^{iwt}$
$2e^{iw_0t}$
$-2ie^{iw_0t}$

FIG 6

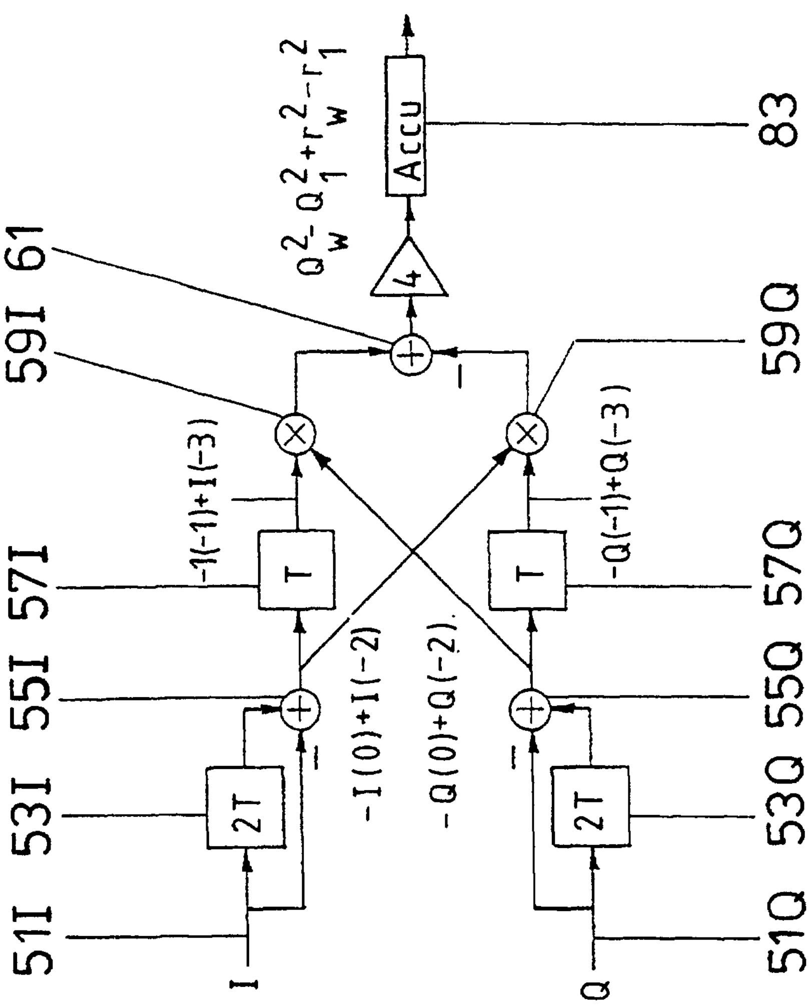
51I
53I
55I
57I
59I
61
51Q
53Q
55Q
57Q
59Q
83
I
Q
2T
T
Accu
4
-I(0)+I(-2)
-Q(0)+Q(-2)
-I(-1)+I(-3)
-Q(-1)+Q(-3)